# EUROPEAN PATENT APPLICATION

(11) **EP 4 403 667 A1**
(43) Date of publication of application: **24.07.2024**
(21) Application number: 23825363.7
(22) Date of filing: 01.01.2023
(51) Int. Cl.: C23C 14/02, C23C 14/14, C23C 14/24, C23C 14/34

(54) **POLYMER BASE FILM SURFACE TREATMENT METHOD AND DEVICE, AND COATED PRODUCT**

(30) Priority: 07.12.2022 CN 202211563028
(71) Applicant: Chongqing Jimat New Material Technology Co., Ltd., Qijiang District, Chongqing 401421 (CN)
(72) Inventor: ZANG, Shiwei, Qijiang District, Chongqing 401421 (CN)
(74) Representative: Bayramoglu et al.
(86) International application number: PCT/CN2023/070002
(87) International publication number: WO 2024/119580

(57) **Abstract**

The present disclosure discloses a method and device for treating a surface of a polymer base film and a coated film product. The method includes: arranging a surface modification apparatus at a discharge end of the polymer base film to be coated, such that an active interface is formed on the surface of the polymer base film to produce a chemical bonding reaction with a coating material. The device includes an unwinding roller, a winding roller, and a coating layer deposition zone, where an ultraviolet (UV) radiation apparatus is provided at one or two sides of a polymer base film between the coating layer deposition zone and the unwinding roller. The coated film product includes a polymer base film, a reinforcement layer, and a functional coating layer, where the reinforcement layer is provided to enhance an adhesion force between the functional coating layer and the polymer base film, and is formed through active interfacial chemical bonding between a coating material and the surface of the polymer base film. In the present disclosure, a surface of a polymer base film is irradiated by a UV radiation apparatus, such that an active interface is formed on the surface to increase an adhesion force between a coating layer and the polymer base film, which can conveniently allow a surface treatment of the polymer base film with no pollution and high efficiency.

## Description

### TECHNICAL FIELD

The present disclosure relates to the technical field of coated films, and specifically relates to a method and device for treating a surface of a polymer base film, and a coated film product.

### BACKGROUND

At present, the most widely-used way to further improve the functionalization and application fields of polymer base films is to compound a functional coating layer with a polymer base film, that is, a coating layer is deposited on a surface of the polymer base film to produce a composite material with blocking and electrically-conductive functions. One of the important characteristics of coated film products is a coating layer having excellent adhesion performance; and the surface of the base film is generally modified by a physical method (such as plasma and corona) or a chemical method (such as surface grafting modification) to enhance the adhesion of a coating.

However, among the existing modification methods, the modification method of plasma bombardment in a vacuum environment involves relatively-complicated equipment structures, and can hardly ensure a long-term production run due to the operation and maintenance of the plasma device. The corona treatment before coating requires an additional procedure. The surface grafting modification method requires an additional procedure, may cause pollution of a surface of a base film, and involves a relatively-complicated equipment system.

The above defects need to be solved.

### SUMMARY

In order to overcome the defects of inconvenient surface treatment and complicated system structures of the polymer base films in the prior art, the present disclosure provides a method and device for treating a surface of a polymer base film, and a coated film product.

The present disclosure adopts the following technical solutions:
The present disclosure provides a method for treating a surface of a polymer base film, including: arranging a surface modification apparatus at a discharge end of the polymer base film to be coated, such that an active interface is formed on the surface of the polymer base film to produce a chemical bonding reaction with a coating material.

According to the present disclosure of the above solution, the method includes: arranging an ultraviolet (UV) radiation apparatus at the discharge end of the polymer base film to be coated, such that the surface of the polymer base film is irradiated to induce introduction of an oxygen-containing group.

According to the present disclosure of the above solution, the method includes: arranging a trace gas distribution pipeline at the discharge end of the polymer base film to be coated, where the trace gas distribution pipeline is configured to deliver an oxygen-containing atmosphere to the surface of the polymer base film.

In another aspect, the present disclosure provides a device for treating a surface of a polymer base film, including an unwinding roller, a winding roller, and a coating layer deposition zone located between the unwinding roller and the winding roller, where the polymer base film is unwound by the unwinding roller, passes through the coating layer deposition zone, and then is wound on the winding roller; and
a UV radiation apparatus is provided between the coating layer deposition zone and the unwinding roller, and the UV radiation apparatus is configured to irradiate one or two sides of the polymer base film to form an active interface on the surface.

According to the present disclosure of the above solution, a radiation intensity of the UV radiation apparatus is positively correlated with a traveling speed of the polymer base film.

According to the present disclosure of the above solution, a distance of the UV radiation apparatus to the polymer base film is inversely correlated with a traveling speed of the polymer base film.

According to the present disclosure of the above solution, a trace gas distribution pipeline is further provided between the UV radiation apparatus and the unwinding roller, and the trace gas distribution pipeline is arranged at one or two sides of the polymer base film and is configured to deliver an oxygen-containing atmosphere to the surface of the polymer base film.

According to the present disclosure of the above solution, the coating layer deposition zone includes a functional layer-coating assembly, and the functional layer-coating assembly is located at one or two sides of the polymer base film.

The present disclosure also provides a coated film product, including a polymer base film and a functional coating layer located on a surface of the polymer base film, where a reinforcement layer for enhancing an adhesion force between the functional coating layer and the polymer base film is provided between the polymer base film and the functional coating layer, and the reinforcement layer is formed through active interfacial chemical bonding between a coating material and the surface of the polymer base film.

According to the present disclosure of the above solution, a buffer layer is further provided between the polymer base film and the functional coating layer, the reinforcement layer is located between the buffer layer and the polymer base film, and the reinforcement layer is formed through active interfacial chemical bonding between a raw material of the buffer layer and the surface of the polymer base film.

The present disclosure of the above solution has the following beneficial effects: In the present disclosure, a UV radiation apparatus is introduced inside a vacuum cavity for coating, and a surface of a polymer base film is irradiated by the UV radiation apparatus, such that an active interface is formed on the surface to allow conditions for chemical bonding with a coating layer during subsequent deposition on the surface of the polymer base film, thereby increasing an adhesion force between the coating layer and the polymer base film; and the entire coating system does not require an additional huge modification device, which can conveniently allow a surface treatment of the polymer base film with no pollution and high efficiency.

### BRIEF DESCRIPTION OF THE DRAWINGS

FIG. 1 is a schematic structural diagram of Embodiment 1 of the present disclosure;
FIG. 2 is a schematic structural diagram of Embodiment 2 of the present disclosure;
FIG. 3 is a schematic structural diagram of Embodiment 3 of the present disclosure;
FIG. 4 is a schematic structural diagram of Embodiment 4 of the present disclosure;
FIG. 5 is a schematic structural diagram of Embodiment 5 of the present disclosure;
FIG. 6 is a schematic structural diagram of Embodiment 6 of the present disclosure;
FIG. 7 is a schematic structural diagram of Embodiment 7 of the present disclosure;
FIG. 8 is a schematic structural diagram of Embodiment 8 of the present disclosure;
FIG. 9 is a schematic structural diagram of Embodiment 9 of the present disclosure;
FIG. 10 is a schematic structural diagram of a coated film product in a specific embodiment of the present disclosure; and
FIG. 11 is a schematic structural diagram of a coated film product in another specific embodiment of the present disclosure.

Reference numerals:
10: unwinding roller; 11: unwinding over roller; 12: UV radiation apparatus; 13: trace gas distribution pipeline;
20: winding roller; 21: winding flattening roller;
30: coated film product; 31: polymer base film; 32: alumina layer; 33: aluminum layer; 34: titanium oxide layer; 35: titanium layer;
40: first coating assembly; 41: first coating cold roller; 42: first evaporation mechanism; 43: first coating flattening roller; 44: first coating over roller; 45: first target;
50: second coating assembly; 51: second coating cold roller; 52: second evaporation mechanism; 53: second coating flattening roller; 54: second coating over roller; 55: second target;
60: third coating assembly; 61: third coating cold roller; 62: third evaporation mechanism; 63: third target;
70: fourth coating assembly; 71: fourth coating cold roller; 72: fourth evaporation mechanism; and 73: fourth target.

### DETAILED DESCRIPTION OF THE EMBODIMENTS

The present disclosure is further described below in combination with the accompanying drawings and embodiments.

In order to allow a surface treatment of a polymer base film in a simple way in a vacuum coating environment such that a structure enabling chemical bonding with a coating layer is formed on a film to be coated to improve an adhesion capacity of the coating layer, the present disclosure provides a method for treating a surface of a polymer base film, including: arranging a surface modification apparatus at a discharge end of the polymer base film to be coated, such that an active interface is formed on the surface of the polymer base film to produce a chemical bonding reaction with a coating material, which allows modification of the surface of the polymer base film.

The surface modification apparatus is a UV radiation apparatus, that is, the UV radiation apparatus is arranged at the discharge end of the polymer base film, such that substances such as water molecules and oxygen molecules on the surface of the polymer base film are irradiated to induce introduction of oxygen-containing groups on the surface of the polymer base film. Specifically, in a vacuum cavity of a vacuum winding coating device, the surface of the polymer base film is irradiated by the UV radiation apparatus, such that the introduction of oxygen-containing groups can be induced. The oxygen-containing groups include single-bond oxygen (C-O-C and C-OH), carbonyl (C=O), carboxyl (COOH), and the like. The oxygen-containing groups can provide an active interface for the subsequent deposition of a coating layer on the polymer base film; and through a chemical bonding reaction between a coating material (such as a metal) and the oxygen-containing groups, a chemical valence bond structure can be constructed at the interface, which can finally allow an effect of enhancing an adhesion force between the coating layer and the interface of the polymer base film.

During the subsequent coating, the polymer base film with the active interface enters the coating layer deposition zone, and a coating material in the coating layer deposition zone is chemically bonded with the active interface to form a reinforcement layer to enhance the adhesion between the coating layer and the surface of the polymer base film. Specifically, the coating material in the coating layer deposition zone can be a metal material, and the metal in the coating layer deposition zone can be chemically bonded with the active interface to produce a metal oxide to enhance the adhesion between the coating layer and the surface of the polymer base film.

The metal material can include Ti and Ti alloy materials, Al and Al alloy materials, and Cr and Cr alloy materials that have excellent buffer and adhesion properties. That is, when the metal material is deposited by evaporation, magnetron sputtering, or the like and an atomic-level or ionic-level material with a very high activity is attached to the surface of the polymer base film, the material easily reacts with the active interface of the polymer base film to produce similar components such as TiOx, CrOx, and alumina for chemical bonding, thereby enhancing the adhesion performance between the coating layer and the surface of the polymer base film.

A material of the polymer base film can be selected from the group consisting of polyethylene terephthalate (PET), polyimide (PI), polyphenylene sulfide (PPS), polypropylene (PP), polyethylene (PE), polycarbonate (PC), polyethylene naphthalate (PEN), polystyrene (PS), polyamide (PA), polytetrafluoroethylene (PTFE), ethylene-vinyl acetate copolymer (PES), polyetherimide (PEI), and polyetheretherketone (PEEK). The method of the present disclosure is significantly suitable for polymer base films with non-polar characteristics.

The UV radiation apparatus can be a UV radiation lamp, and the UV radiation lamp can be a ready-made product with a UVA band (wavelength: 320 nm to 420 nm, also known as long-wave black spot effect UV rays), UVB band (wavelength: 275 nm to 320 nm, also known as medium-wave red spot effect UV rays), UVC band (wavelength: 200 nm to 275 nm, also known as short-wave sterilization UV rays), or UVD band (wavelength: 100 nm to 200 nm, also known as vacuum UV rays) on the market. UV rays generated by the UV radiation apparatus are absorbed by polymer groups of the polymer base film, such that the polymer groups are broken and react with substances such as water molecules and oxygen molecules adsorbed on a surface of the polymer groups to produce new groups with single-bond oxygen and double-bond oxygen. Appropriate UV light can excite the breakage of oxygen molecular bonds to produce atomic oxygen, such that a modified base film surface with increased highly-active groups or interfaces is ultimately obtained.

Further, in order to allow the generation of increased oxygen-containing groups on a surface of a polymer base film, a trace gas distribution pipeline is arranged at a discharge end of the polymer base film to be coated, where the trace gas distribution pipeline is configured to deliver an oxygen-containing atmosphere to the surface of the polymer base film. The trace gas distribution pipeline is connected to a flow controller, and with an accurate flow controller, the trace gas distribution pipeline can allow the introduction of an oxygen-containing atmosphere without affecting the subsequent deposition of a coating layer. In a specific implementation process, the oxygen-containing atmosphere is introduced in a trace-doping manner, for example, in a mixed atmosphere including Ar with a gas concentration of 99.5% and O₂ with a gas concentration of 0.5%, an ozone source can be used instead of oxygen.

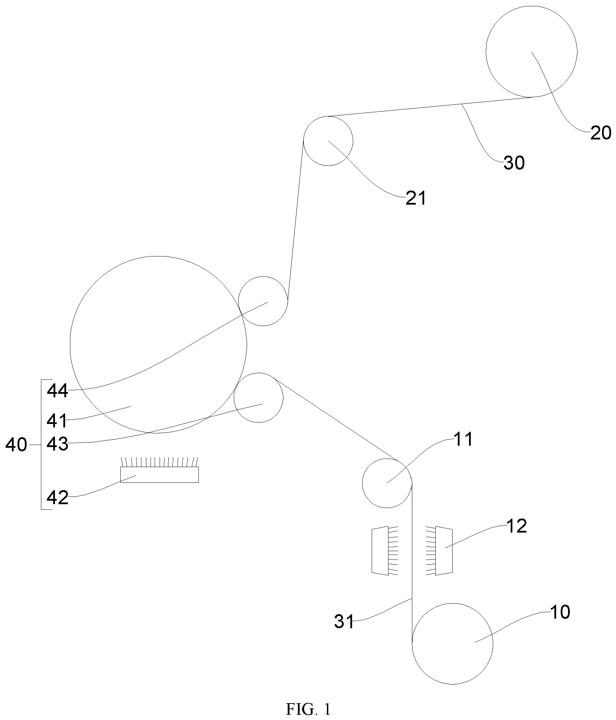

As shown in FIG. 1 to FIG. 9, the present disclosure provides a device for treating a surface of a polymer base film, where a UV radiation apparatus is provided at two sides of a discharge end of a base film to be coated in a vacuum cavity to provide necessary conditions for a surface treatment of the base film.

The device for treating a surface of a polymer base film includes unwinding roller 10, winding roller 20, and a coating layer deposition zone located between the unwinding roller 10 and the winding roller 20, where polymer base film 31 is unwound by the unwinding roller, passes through the coating layer deposition zone, and then is wound on the winding roller 20; the unwinding roller 10 is configured to allow the unwinding of the polymer base film 31; the coating layer deposition zone is configured to allow the coating of a surface of the polymer base film 31; and the winding roller 20 is configured to allow the winding of coated film product 30.

In order to ensure the smoothness of traveling of a film inside the entire coating device and save a space inside the coating device, unwinding over roller 11 is provided between the unwinding roller 10 and the coating layer deposition zone, and after being unwound, the polymer base film 31 first travels around the unwinding over roller 11 and then enters the coating layer deposition zone; and correspondingly, in order to ensure the flatness of the coated film product 30 after being wound, winding flattening roller 21 is provided between a tail end of the coating layer deposition zone and the winding roller 20, and the coated film product 30 first travels around the winding flattening roller 21 and then is wound on the winding roller 20.

In order to increase the adhesion between a coating layer and a polymer base film, a UV radiation apparatus is provided between the coating layer deposition zone and the unwinding roller in the present disclosure, and the UV radiation apparatus is configured to irradiate one or two sides of the polymer base film; and when the unwinding of the polymer base film begins, the UV radiation apparatus begins to work to form an active interface on a surface of the polymer base film.

The UV radiation apparatus is arranged on a position adjustment apparatus; and a distance between the UV radiation apparatus and the polymer base film is adjusted through the position adjustment apparatus, and a radiation distance can be adjusted according to a traveling speed of the polymer base film accordingly. Specifically, a distance of the UV radiation apparatus to the polymer base film is inversely correlated with the traveling speed of the polymer base film. In addition, a radiation intensity of the UV radiation apparatus can also be adjusted according to the traveling speed of the polymer base film. Specifically, the radiation intensity of the UV radiation apparatus is positively correlated with the traveling speed of the polymer base film.

Normally, the traveling speed of the polymer base film is very high, and the traveling speed of the polymer base film is generally 2 m/min to 400 m/min. In this case, the radiation intensity of the UV radiation apparatus is 0.5 mW/cm² to 500 mW/cm², and a distance between the UV radiation apparatus and the polymer base film is 1 cm to 10 cm.

The coating layer deposition zone is configured to allow coating of a surface of a polymer base film, and includes a functional layer-coating assembly arranged at one or two sides of the polymer base film; and when the functional layer-coating assembly is arranged at one side, the one side of the polymer base film is coated, and when the functional layer-coating assembly is arranged at two sides, the two sides of the polymer base film are coated. The functional layer-coating assembly and a buffer layer-coating assembly each include a coating cold roller, a coating evaporation source, a flattening roller, and an over roll; the polymer base film travels around the flattening roller, the coating cold roller, and the over roller sequentially; and the coating evaporation source is located at an outer side of the coating cold roller.

According to needs, the coating layer deposition zone further includes a buffer layer-coating assembly; in a traveling direction of the polymer base film, the buffer layer-coating assembly is located in front of the functional layer-coating assembly; and a buffer layer can be coated on a surface of a polymer base film through the buffer layer-coating assembly, and subsequently, a functional coating layer can be coated through the functional layer-coating assembly, thereby allowing buffering and further enhancement for the surface of the polymer base film.

### Embodiment 1

As shown in FIG. 1, in this embodiment, a UV radiation lamp of a UV radiation apparatus is arranged at two sides of a polymer base film, and a radiation intensity of the UV radiation lamp and a distance of the UV radiation lamp to the polymer base film are adjusted according to a traveling speed of the polymer base film.

Specifically, in this embodiment, a PI base film is adopted as a substrate for a coating material, and a resulting coated film product can have a structure of PI/reinforcement layer/functional layer. In this embodiment, a traveling speed of the polymer base film is 2 m/min, a radiation intensity of the UV radiation lamp is 5 mW/cm², and a radiation distance is 4 cm.

In this embodiment, single-sided vapor deposition is adopted. That is, a functional layer-coating assembly includes a first coating assembly 40; the first coating assembly 40 includes first coating cold roller 41, first evaporation mechanism 42, first coating flattening roller 43, and first coating over roller 44; and the first evaporation mechanism 42 is located at a lower side of the first coating cold roller 41. A polymer base film travels around the first coating flattening roller 43, the first coating cold roller 41, and the first coating over roller 44 sequentially, and passes through the first evaporation mechanism 42, such that the single-sided vapor deposition is completed.

The functional coating layer can be a metal coating layer, a metal compound coating layer, or the like.

### Embodiment 2

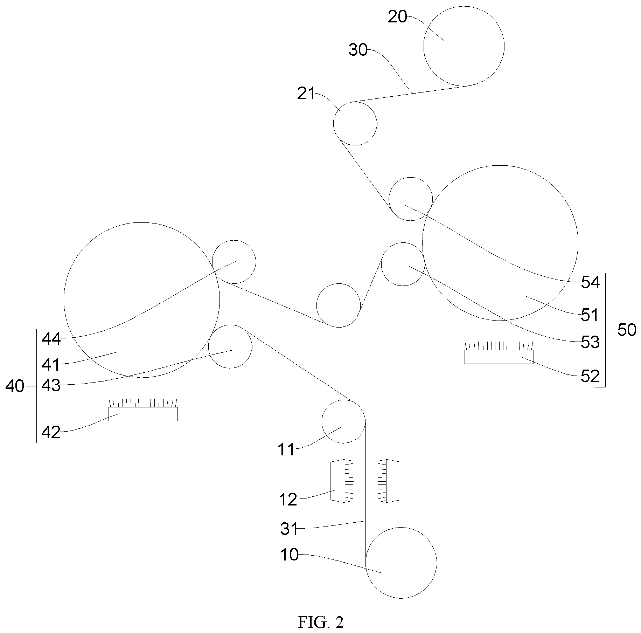

As shown in FIG. 2, this embodiment is different from Embodiment 1 in that two-sided vapor deposition is adopted in this embodiment. That is, the functional layer-coating assembly includes first coating assembly 40 and second coating assembly 50. Specifically, the first coating assembly 40 includes first coating cold roller 41, first evaporation mechanism 42, first coating flattening roller 43, and first coating over roller 44, where the first evaporation mechanism 42 is located at a lower side of the first coating cold roller 41; and the second coating assembly 50 includes second coating cold roller 51, second evaporation mechanism 52, second coating flattening roller 53, and second coating over roller 54, where the second evaporation mechanism 52 is located at a lower side of the second coating cold roller 51.

A polymer base film travels around the first coating flattening roller 43, the first coating cold roller 41, and the first coating over roller 44 sequentially, and passes through the first evaporation mechanism 42, such that the vapor deposition is completed for one side; and then the polymer base film travels around the second coating flattening roller 53, the second coating cold roller 51, and the second coating over roller 54 sequentially, and passes through the second evaporation mechanism 52, such that the vapor deposition is completed for the other side.

### Embodiment 3

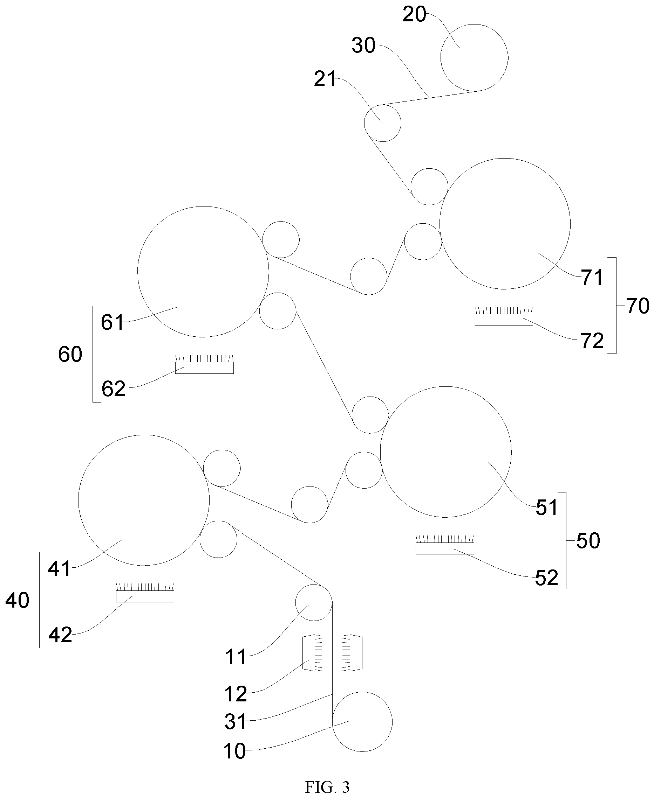

As shown in FIG. 3, this embodiment is different from Embodiment 2 in that a buffer layer is vapor-deposited at two sides through a buffer layer-coating assembly before a functional layer is applied in this embodiment.

The buffer layer-coating assembly includes first coating assembly 40 and second coating assembly 50; the first coating assembly 40 includes first coating cold roller 41, first evaporation mechanism 42, and a first coating flattening roller and a first coating over roller corresponding to the first coating cold roller 41; and the second coating assembly 50 includes second coating cold roller 51, second evaporation mechanism 52, and a second coating flattening roller and a second coating over roller corresponding to the second coating cold roller 51. A polymer base film travels around the first coating flattening roller, the first coating cold roller 41, and the first coating over roller sequentially, and passes through the first evaporation mechanism 42, such that the vapor deposition of a buffer layer is completed for one side; and then the polymer base film travels around the second coating flattening roller, the second coating cold roller 51, and the second coating over roller sequentially, and passes through the second evaporation mechanism 52, such that the vapor deposition of a buffer layer is completed for the other side.

A functional layer-coating assembly includes third coating assembly 60 and fourth coating assembly 70; the third coating assembly 60 includes third coating cold roller 41, third evaporation mechanism 62, and a third coating flattening roller and a third coating over roller corresponding to the third coating cold roller 61; and the fourth coating assembly 70 includes fourth coating cold roller 71, fourth evaporation mechanism 72, and a fourth coating flattening roller and a fourth coating over roller corresponding to the fourth coating cold roller 71. A polymer base film travels around the third coating flattening roller, the third coating cold roller 61, and the third coating over roller sequentially, and passes through the third evaporation mechanism 62, such that the vapor deposition of a functional coating layer is completed for one side; and then the polymer base film travels around the fourth coating flattening roller, the fourth coating cold roller 71, and the fourth coating over roller sequentially, and passes through the fourth evaporation mechanism 72, such that the vapor deposition of a functional coating layer is completed for the other side.

In a specific implementation process, the buffer layer may be Ti or a Ti alloy or Cr or a Cr alloy; and the functional coating layer is mostly a metal coating layer, a metal compound coating layer, or the like. In this embodiment, the metal Ti is adopted as the buffer layer, the metal Al is adopted as the functional coating layer, and a final coating layer (including the buffer layer and the functional coating layer) has a total thickness of 150 nm.

### Embodiment 4

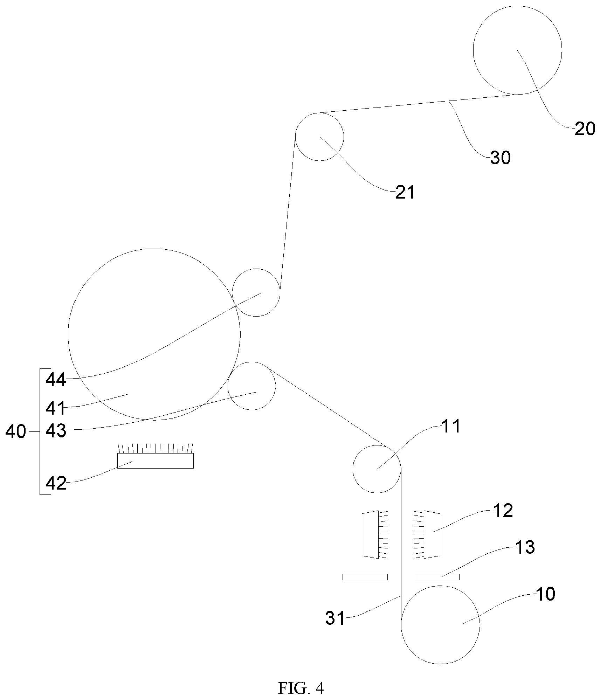

As shown in FIG. 4, this embodiment is different from Embodiment 1 in that a trace amount of an oxygen-containing atmosphere is first introduced before irradiation of a UV radiation apparatus in this embodiment. That is, trace gas distribution pipeline 13 is provided between UV radiation apparatus 12 and unwinding roller 10, and the trace gas distribution pipeline 13 is arranged at one or two sides of polymer base film 31 and is configured to deliver an oxygen-containing atmosphere to a surface of the polymer base film 31.

In this embodiment, vapor deposition is adopted, and a trace amount of an oxygen-containing atmosphere is introduced through the trace gas distribution pipeline 13 to produce a reinforcement layer (such as alumina). Since only a trace amount of an oxygen-containing atmosphere is introduced, groups with single-bond oxygen and double-bond oxygen have been generated in the oxygen-containing atmosphere, and there is a specified distance between the trace gas distribution pipeline 13 and a vapor-deposited layer, the oxygen-containing atmosphere introduced will hardly affect the vapor-deposited layer. In addition, when chemically bonded with a metal to produce an oxide reinforcement layer, the oxygen-containing groups generated in the oxygen-containing atmosphere have been consumed, and thus will not affect the subsequent formation of a functional coating layer.

### Embodiment 5

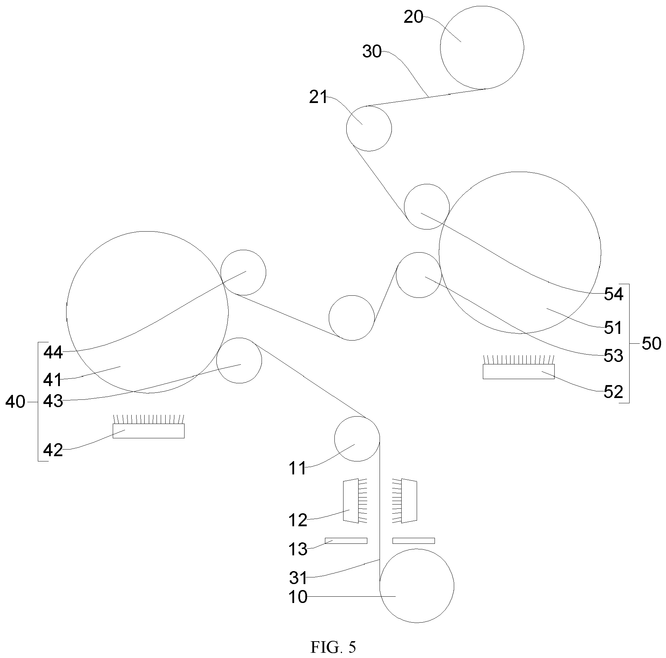

As shown in FIG. 5, this embodiment is different from Embodiment 2 in that trace gas distribution pipeline 13 is further provided between the UV radiation apparatus 12 and the unwinding roller 10.

### Embodiment 6

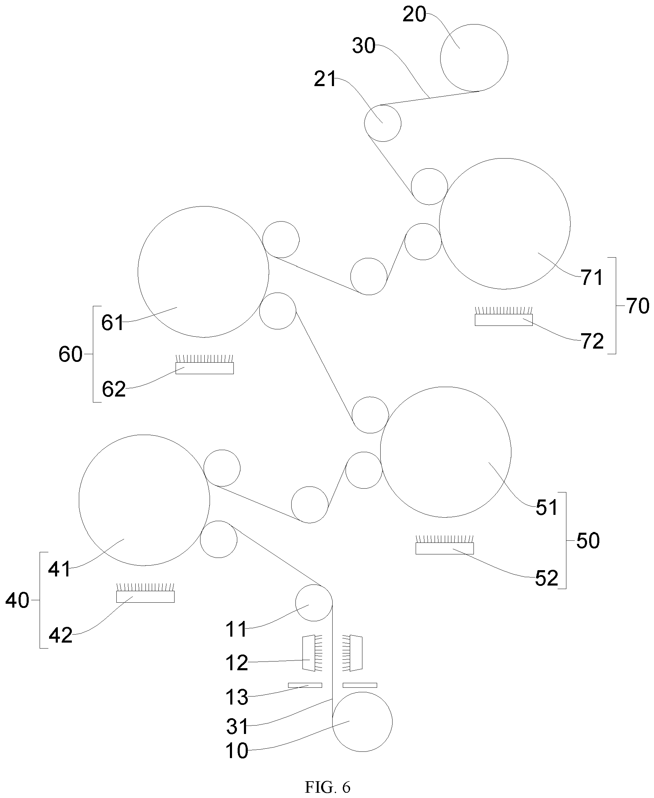

As shown in FIG. 6, this embodiment is different from Embodiment 3 in that trace gas distribution pipeline 13 is further provided between the UV radiation apparatus 12 and the unwinding roller 10.

### Embodiment 7

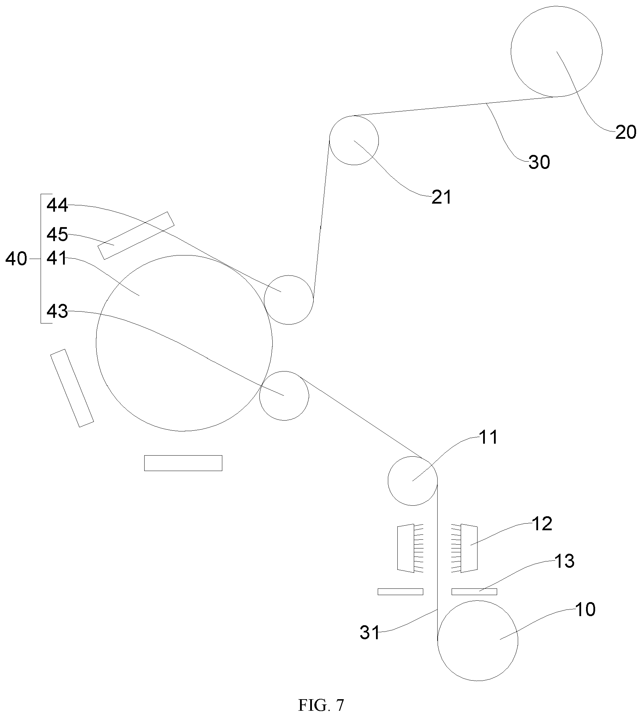

As shown in FIG. 7, this embodiment is different from Embodiment 4 in that a functional coating layer is applied through sputtering in this embodiment, that is, a plurality of first targets 45 are provided on a periphery of the first coating cold roller 41, and the functional coating layer is applied through sputtering with the first targets 45.

In this embodiment, a coating is applied through sputtering, and a gas for sputtering needs to be introduced during the sputtering. In this embodiment, trace gas distribution pipeline 13 is provided at a discharge end of the unwinding roller 10 to introduce an oxygen-containing atmosphere, and a concentration of the sputtering gas is much higher than a concentration of the oxygen-containing atmosphere; and because a large amount of the sputtering gas diffuses, the oxygen-containing atmosphere does not diffuse to a sputtered layer, and there is a specified distance between the trace gas distribution pipeline 13 and the sputtered layer, the introduced oxygen-containing atmosphere will not affect the sputtered layer.

### Embodiment 8

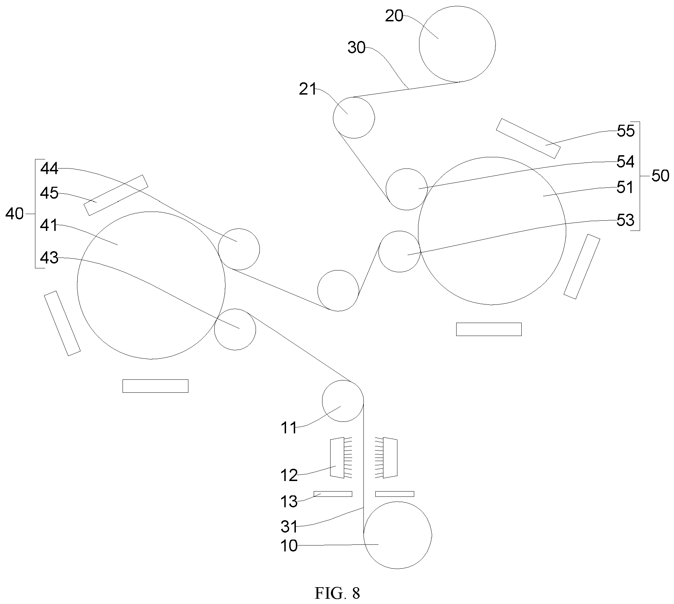

As shown in FIG. 8, this embodiment is different from Embodiment 5 in that a functional coating layer is applied through sputtering in this embodiment. That is, a plurality of first targets 45 are provided on a periphery of the first coating cold roller 41, and one side of a polymer base film is sputtered through the first targets 45; and a plurality of second targets 55 are provided on a periphery of the second coating cold roller 51, and the other side of the polymer base film is sputtered through the second targets 55.

### Embodiment 9

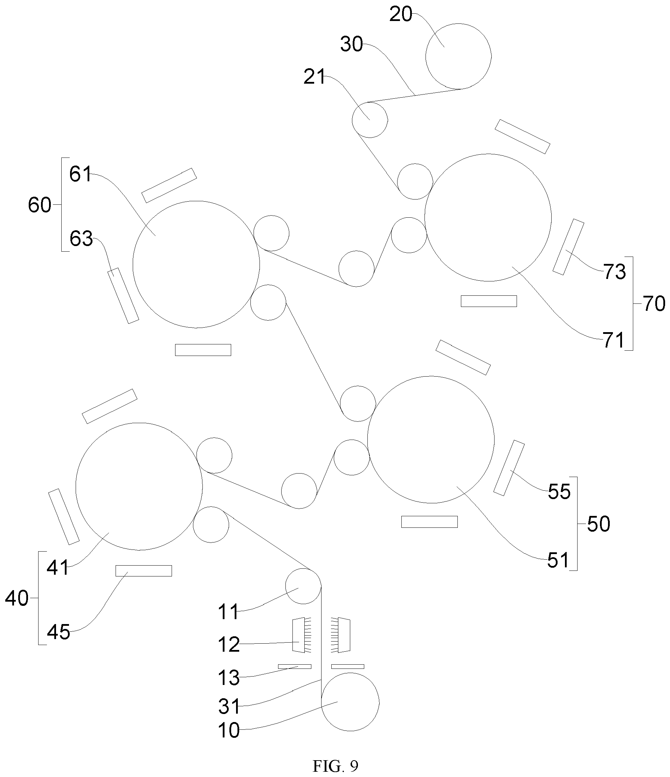

As shown in FIG. 9, this embodiment is different from Embodiment 6 in that a buffer layer and a functional coating layer are applied through sputtering in this embodiment. That is, a plurality of first targets 45 are provided on a periphery of the first coating cold roller 41, and one side of polymer base film 31 is sputtered through the first targets 45 to form a buffer layer; a plurality of second targets 55 are provided on a periphery of the second coating cold roller 51, and the other side of the polymer base film is sputtered through the second targets 55 to form a buffer layer; a plurality of third targets 63 are provided on a periphery of the third coating cold roller 61, and one side of polymer base film 31 is sputtered through the third targets 63 to form a functional coating layer; and a plurality of fourth targets 73 are provided on a periphery of the fourth coating cold roller 71, and the other side of the polymer base film is sputtered through the fourth targets 73 to form a functional coating layer.

In the above embodiments, the vapor deposition requires an evaporation mechanism; and the sputtering requires arrangement of a target and introduction of a gas such as argon. Moreover, in a vacuum cavity, when it is necessary to coat two sides of a polymer base film, two coating cold rollers are adopted, and the two coating cold rollers adopt a same coating manner, for example, the two coating cold rollers both adopt vapor deposition or sputtering.

It should be noted that the above coating processes all are conducted in a vacuum environment; and when sputtering is adopted, a gas for sputtering needs to be introduced. When a trace gas distribution pipeline is provided, because a concentration of the oxygen-containing atmosphere is much lower than a concentration of the sputtering gas, a large amount of the sputtering gas diffuses, the oxygen-containing atmosphere does not diffuse to a sputtered layer, and there is a specified distance between the trace gas distribution pipeline and the sputtered layer, the introduced oxygen-containing atmosphere will not affect the sputtered layer.

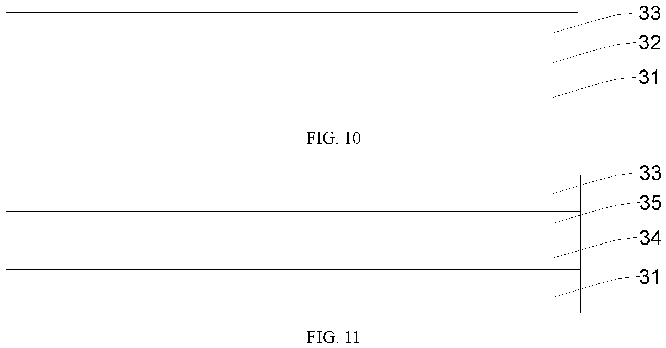

As shown in FIG. 10 and FIG. 11, the present disclosure also provides a coated film product, and an adhesion force of the coated film product is improved by 100% or more compared with an adhesion force before modification, and reaches 600 N/m. The coated film product includes a polymer base film and a functional coating layer located on a surface of the polymer base film, where a reinforcement layer for enhancing an adhesion force between the functional coating layer and the polymer base film is provided between the polymer base film and the functional coating layer, and the reinforcement layer is formed through active interfacial chemical bonding between a coating material and the surface of the polymer base film.

Specifically, in FIG. 10, the coated film product 30 includes polymer base film 31, aluminum layer 33 as a functional coating layer, and alumina layer 32 as a reinforcement layer between the polymer base film 31 and the aluminum layer 33, where the alumina layer 32 is formed through active interfacial chemical bonding between a raw material aluminum of the aluminum layer 33 and a surface of the polymer base film 31. The coated film product is obtained by directly depositing aluminum, and when the metal aluminum contacts a surface of the polymer base film 31, the alumina layer 32 is formed first, and then the aluminum layer 33 is formed. A thickness of the functional coating layer (the aluminum layer 33) is controlled at 200 nm to 1,500 nm according to product needs, and a thickness of the reinforcement layer (the alumina layer 33) is controlled at 10 nm or less; and when the trace gas distribution pipeline shown in FIG. 4 or FIG. 7 is provided to introduce an oxygen-containing atmosphere, the thickness of the alumina layer is increased (which is greater than 10 nm and less than or equal to 25 nm) and an adhesion force is enhanced.

In a preferred embodiment shown in FIG. 11, a buffer layer is further provided between the polymer base film and the functional coating layer, where the reinforcement layer is located between the buffer layer and the polymer base film, and the reinforcement layer is formed through active interfacial chemical bonding between a raw material of the buffer layer and a surface of the polymer base film.

Specifically, as shown in FIG. 11, the coated film product 30 includes polymer base film 31, aluminum layer 33 as a functional coating layer, titanium oxide layer 34 (TiOx layer) as a reinforcement layer between the polymer base film 31 and the aluminum layer 33, and titanium layer 35 as a buffer layer, where the reinforcement layer is formed through active interfacial chemical bonding between a raw material titanium of the buffer layer and a surface of the polymer base film 31.

Before the functional coating layer (the aluminum layer 33) is formed, the titanium oxide layer 34 is formed, then the titanium layer 35 is formed, and finally the aluminum layer 33 is formed. When a trace gas distribution pipeline is provided to introduce an oxygen-containing atmosphere, the thickness of the titanium oxide layer 34 is increased and an adhesion force is enhanced. In an embodiment, in the case where the oxygen-containing atmosphere is introduced, a thickness of the titanium oxide layer 35 is 25 nm or less (which is generally 10 nm or less in the case where a trace oxygen-containing atmosphere is not introduced), a thickness of the titanium layer 35 is 200 nm to 800 nm, and a thickness of the aluminum layer 33 is 200 nm to 800 nm.

In the above specific embodiment, the aluminum layer is adopted as a functional coating layer, which may be applied through vapor deposition or sputtering; and the functional coating layer can also be a copper layer, which may also be applied through vapor deposition or sputtering.

The present disclosure also provides comparative experiments.

Embodiment 1 (a basic embodiment) is illustrated as an example. Coated film sample AA1 was prepared when the UV radiation apparatus was not turned on; and coated film sample AA2 with a reinforcement layer was prepared when the UV radiation apparatus was turned on.

### 1. Comparison of the coated film sample AA1 with the coated film sample AA2 in terms of an adhesion force

A tape with a width of 20 mm and a peeling force of 1,000 N/m was applied to a surface of each of the coated film sample AA1 and the coated film sample AA2, and then a tensile test was conducted with a tensile machine at 180° and 50 mm/min to determine an adhesion force of a coating layer. An adhesion force of the coated film sample AA1 reached 287 N/m, and an adhesion force of the coated film sample AA2 reached 749 N/m.

An adhesion force of a coated film sample enhanced by the method of the present disclosure was significantly improved.

### 2. Comparison of the coated film sample AA1 with the coated film sample AA2 in terms of adhesion performance

In the present disclosure, an electrolytic environment for a lithium-ion battery (LIB) was simulated, and the coated film sample AA1 and the coated film sample AA2 each were soaked in a chemical agent and then tested for adhesion performance.

Specifically, the coated film sample AA1 and the coated film sample AA2 each were soaked in a conventional LIB electrolyte, then baked at 85°C for 72 h, and then tested. Test results showed that, after the soaking, the two samples still retained excellent adhesion performance, where adhesion forces of the coated film sample AA1 and the coated film sample AA2 were 213 N/m and 688 N/m, respectively, which were 74% and 92% of initial values, respectively.

Thus, after enhancement by the method of the present disclosure, the coated film sample AA2 retains an excellent adhesion performance advantage.

### 3. Comparison of the coated film sample AA1 with the coated film sample AA2 in terms of a mechanical strength

A sample with a width of 10 mm was taken as an example, and a tensile strength of the sample was tested with a tensile speed of 50 mm/min, where a tensile strength of the coated film sample AA1 could reach 195 MPa and a tensile strength of the coated film sample AA2 could reach 231 Mpa.

In the present disclosure, the method and device for treating a surface of a polymer base film can allow a pollution-free surface treatment for a polymer base film. Compared with the traditional direct deposition of a coating layer on a film without a surface treatment, the method of the present disclosure improves the adhesion performance two times or more. In addition, because a reinforcement layer is formed through chemical bonding and a metal oxide component as the reinforcement layer can play a role of interface passivation in the present disclosure, a resulting coated film material has an excellent chemical agent-resistant effect and a significantly-improved mechanical strength (tensile strength).

It should be understood that those of ordinary skill in the art can make modifications and variations based on the above description, and these modifications and variations should fall within the protection scope of the appended claims of the present disclosure.

The present disclosure has been exemplarily described above with reference to the accompanying drawings. Apparently, the implementation of the present disclosure is not limited by the above manner. Various improvements made based on the method concept and technical solutions of the present disclosure or direct application of the concept and the technical solutions of the present disclosure to other occasions without improvement shall fall within the protection scope of the present disclosure.

## Claims

1. A method for treating a surface of a polymer base film, comprising: arranging a surface modification apparatus at a discharge end of the polymer base film to be coated, such that an active interface is formed on the surface of the polymer base film to produce a chemical bonding reaction with a coating material.

2. The method for treating a surface of a polymer base film according to claim 1, comprising: arranging an ultraviolet (UV) radiation apparatus at the discharge end of the polymer base film to be coated, such that the surface of the polymer base film is irradiated to induce introduction of an oxygen-containing group.

3. The method for treating a surface of a polymer base film according to claim 1, comprising: arranging a trace gas distribution pipeline at the discharge end of the polymer base film to be coated, wherein the trace gas distribution pipeline is configured to deliver an oxygen-containing atmosphere to the surface of the polymer base film.

4. A device for treating a surface of a polymer base film, comprising an unwinding roller, a winding roller, and a coating layer deposition zone located between the unwinding roller and the winding roller, wherein the polymer base film is unwound by the unwinding roller, passes through the coating layer deposition zone, and then is wound on the winding roller; and
a UV radiation apparatus is provided between the coating layer deposition zone and the unwinding roller, and the UV radiation apparatus is configured to irradiate one or two sides of the polymer base film to form an active interface on the surface.

5. The device for treating a surface of a polymer base film according to claim 4, wherein a radiation intensity of the UV radiation apparatus is positively correlated with a traveling speed of the polymer base film.

6. The device for treating a surface of a polymer base film according to claim 4, wherein a distance of the UV radiation apparatus to the polymer base film is inversely correlated with a traveling speed of the polymer base film.

7. The device for treating a surface of a polymer base film according to claim 4, wherein a trace gas distribution pipeline is further provided between the UV radiation apparatus and the unwinding roller, and the trace gas distribution pipeline is arranged at one or two sides of the polymer base film and is configured to deliver an oxygen-containing atmosphere to the surface of the polymer base film.

8. The device for treating a surface of a polymer base film according to claim 4, wherein the coating layer deposition zone comprises a functional layer-coating assembly, and the functional layer-coating assembly is located at one or two sides of the polymer base film.

9. A coated film product, comprising a polymer base film and a functional coating layer located on a surface of the polymer base film, wherein a reinforcement layer for enhancing an adhesion force between the functional coating layer and the polymer base film is provided between the polymer base film and the functional coating layer, and the reinforcement layer is formed through active interfacial chemical bonding between a coating material and the surface of the polymer base film.

10. The coated film product according to claim 9, wherein a buffer layer is further provided between the polymer base film and the functional coating layer, the reinforcement layer is located between the buffer layer and the polymer base film, and the reinforcement layer is formed through active interfacial chemical bonding between a raw material of the buffer layer and the surface of the polymer base film.
